Europäisches Patentamt

European Patent Office

Office européen des brevets

(19)

(11) **EP 0 365 876 B1**

(12) # EUROPEAN PATENT SPECIFICATION

(45) Date of publication and mention
of the grant of the patent:
**25.09.1996 Bulletin 1996/39**

(51) Int Cl.6: **G11C 5/02**, G11C 8/00,
G11C 11/408

(21) Application number: **89118312.1**

(22) Date of filing: **03.10.1989**

(54) **Decoding global drive/boot signals using local predecoders**

Dekodierung von Steuer-/Initialisierungssignalen mit örtlichen Vordekodierern

Décodage de signaux d'attaque/d'initialisation utilisant des prédécodeurs locaux

(84) Designated Contracting States:
**DE FR GB IT NL**

(30) Priority: **28.10.1988 US 264404**

(43) Date of publication of application:
**02.05.1990 Bulletin 1990/18**

(60) Divisional application: **94113312.6**

(73) Proprietor: **TEXAS INSTRUMENTS
INCORPORATED
Dallas Texas 75265 (US)**

(72) Inventors:
• **Kersh, David V., III
Houston Texas 77036 (US)**

• **Childers, Jimmie Don
Missouri City Texas 77489 (US)**

(74) Representative: **Leiser, Gottfried, Dipl.-Ing. et al
Prinz & Partner,
Manzingerweg 7
81241 München (DE)**

(56) References cited:
**DE-A- 3 447 722**     **FR-A- 2 551 904**
**GB-A- 2 149 163**

• **PATENT ABSTRACTS OF JAPAN vol. 12, no. 46
(P-665) February 12, 1988 & JP-A-62 192 086**

EP 0 365 876 B1

## Description

The present invention relates in general to dynamic random access memories, and more particularly to a memory device comprising a decoding circuit for decoding a drive signal onto preselected row lines using local predecoders.

A decoding circuit of the kind mentioned in the preamble of claim 1 is disclosed in DE-A-34 47 722.

Industrial users of dynamic random access memories (DRAMs) are demanding ever-quicker timing and ever-smaller power specifications. To meet these specifications, designers must design DRAMs to read from and write to the DRAM storage cells more and more quickly while at the same time using less power. This requires that improved methods be discovered to drive DRAM word lines to $V_{dd}$ during the precharge portion of the reading cycle and to boot them above $V_{dd}$ during the active restore portion of the cycle. These functions are a substantial part of an active cycle's length.

A selected row line is driven for reading, and is booted for the active restore function, using a drive/boot signal transmitted from a drive/boot signal generator conventionally located in a peripheral area of the chip. An increasing importance has been placed on the decoding path of this drive/boot signal from the drive/boot generator to the active word lines. If this decoding path is too resistive or capacitive, the driving and booting of the word lines will be too slow. In addition, if the drive/boot signal path is too capacitive, the device will use too much power.

To illustrate the disadvantages of present drive/boot signal decoding systems, two examples will be described. In a pair of conventional 64K and 256K DRAM designs, one drive/boot generator is provided. Its output is split into two separate global signal lines (that is, signal lines that extend over the entire array) using pass gates. Therefore, only one of the split lines is required to be active in any given cycle. Each of the split lines then connects to one-half of all of the word line drivers or decoders in the DRAM in order to drive and boot the appropriate word lines. The row decoders are selected by addressing signals. Thus, in any given cycle, the one master drive/boot signal will "see" the parasitic capacitance of one-half of all of the word line drivers on the entire chip connected to it, plus the parasitic capacitance of two extra decoding pass gates. In addition to the relatively large amount of capacitance that this creates, the drive/boot signal is required to travel through the resistance of one pass gate and one word line driver to get to each decoded word line.

According to another conventional design used in 256K and IM CMOS DRAMs, four drive/boot generators are provided with four separate global drive/boot signal lines. Only one of these signal lines is active for any given cycle. Each drive/boot signal line is directly connected to one-fourth of all of the word line drivers on the chip. The four generators used according to this method require more space on the chip than one large signal generator. Further, each of the four drive/boot signal lines is heavily loaded with one-fourth of the entire chip's word line drivers parasitic capacitance. Each drive/boot signal must furthermore travel through the resistance of one word line driver to reach each word line.

The above conventional drive/boot signal decoding solutions require that the drive/boot signal "see" an undesirably large amount of parasitic capacitance, thus slowing down cycle times. The importance of minimizing this capacitance increases with increasing cycle speed, smaller voltage differences and larger array sizes such as are mandated for the 4M DRAM. A need has therefore arisen for a drive/boot signal decoding scheme that will result in improved parasitic capacitance characteristics.

One aspect of the invention as defined in claim 1 comprises a decoding circuit for driving a row line associated with at least one row of memory cells in an integrated circuit array having a plurality of such row lines. An array area of the integrated circuit contains the row lines, while a peripheral area of the integrated circuit has formed therein a drive signal generator. A plurality of predecoders are formed in the array area and are coupled to the drive signal generator by a drive signal line for receiving the drive signal. A predetermined multiple of decoders are also formed in the array area for each predecoder. One of a plurality of outputs of at least an addressed one of the predecoders is operable to transmit a predecoded drive signal to each of a respective multiple of decoders. An addressed one of the decoders is in turn operable to transmit a decoded drive signal to at least one of a plurality of word lines coupled thereto.

The peripheral area of the chip also has formed therein an addressing signal generator. Addressing signals are transmitted from the addressing signal generator to each of the predecoders and each of the decoders. Only addressed ones of the predecoders will pass the drive signal onto respective multiples of decoders, and only addressed ones of the decoders will pass the predecoder drive signal onto one or more of the word lines. The addressing signal generator outputs a plurality of row factor signals on respective row factor signal lines according to an address received by the addressing signal generator. A first set of the row factor signals determine which of a plurality of predecoder output lines will carry the drive/boot signal. A second set of the row factor signals select which of the predecoders will be actuated to transfer the drive/boot signal to the predecoder output line. Yet another set of the row factor signals selects at least one decoder for receiving the drive/boot signal on the predecoder output line, and for transmitting the drive/boot signal to the selected word line.

In another aspect of the invention, the apparatus used to decode the main drive signal onto preselected row lines also decodes a booting signal to the same row lines.

A principal advantage of the invention is the reduction of the number of row lines decoders "seen" by the main drive/boot signal. In a 4M DRAM design according to the invention, the parasitic capacitance of only 4/128 of the entire chip's word line drivers, plus the capacitance of an extra 128 predecoding pass gates, is seen by the main drive/boot signal. Each of the extra 128 predecoding pass gates is however about four times larger than each word line driver in order to make the word lines' rise time approximately the same as the rise time if the earlier 256K and 1M CMOS method was used. It is therefore estimated that the parasitic capacitance on the drive/boot line according to the invention, in a given cycle, is approximately equivalent to only one-tenth of the entire chip's word line driver parasitic capacitance. This allows the word lines to be driven faster and at the same time to use less power in doing it.

BRIEF DESCRIPTION OF THE DRAWINGS

The aspects of the invention and their advantages will be discerned by the following detailed description in conjunction with the drawings in which:

FIGURE 1 is a partial schematic plan layout showing a four megabit DRAM design according to the invention;
FIGURE 2 is a simplified schematic electrical layout of a small portion of the DRAM illustrated in FIGURE 1;
FIGURE 3 is a detailed electrical schematic diagram of a single predecoder according to the invention; and
FIGURE 4 is a detailed electrical schematic diagram of a single decoder according to the invention.

DETAILED DESCRIPTION OF THE INVENTION

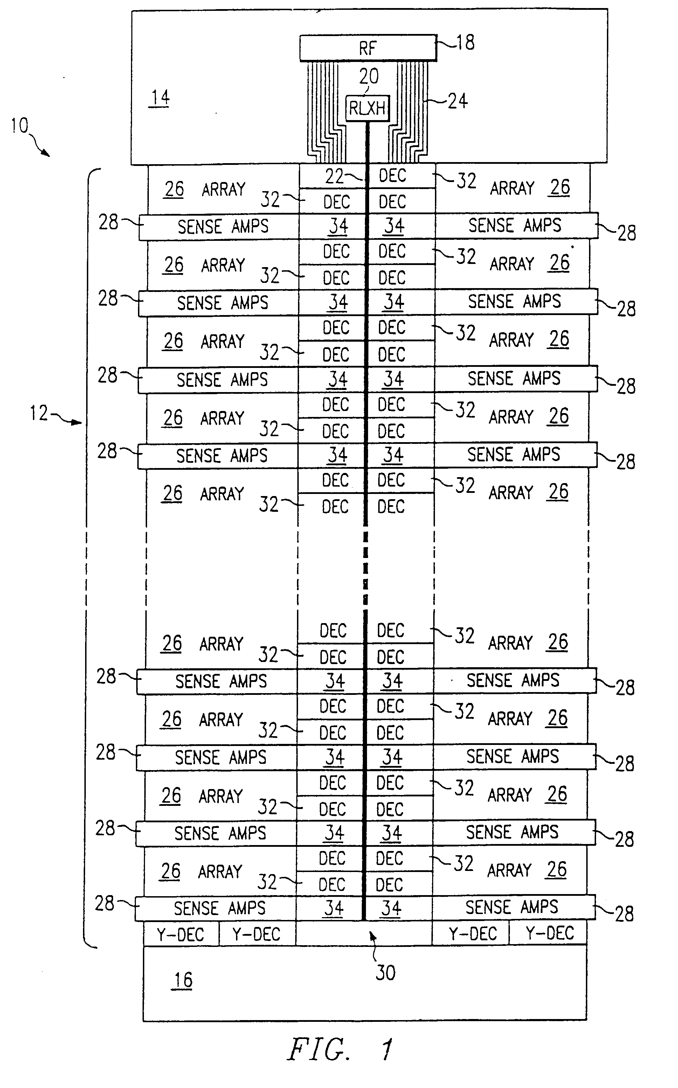

Referring first to FIGURE 1, a layout of a dynamic random access memory (DRAM) chip is shown generally at 10. The particular layout shown is for a four megabit DRAM. The chip 10 includes a cell array area indicated generally at 12, and a pair of end peripheral areas 14 and 16 adjacent the cell array area 12.

In the illustrated embodiment, a row factor signal generator 18 (RF) and a drive/boot signal generator 20 (RLXH) are formed in the peripheral area 14. The size and positioning of signal generators 18 and 20 are shown only schematically. The drive/boot signals generator 20 has an output that is connected to a drive/boot signal generator line 22 that runs down the middle of the array area 12. The row factor signal generator 18 has a plurality of row factor signal lines 24 (schematically illustrated; in one actual embodiment there are twenty such lines 24) that also run down the middle of the array area 12 so as to be substantially parallel to the drive/boot signal line 22.

The array area 12 contains a plurality of DRAM memory cell arrays 26 that are arranged in rows and columns. In the embodiment illustrated, there are thirty-two arrays 26 arranged in sixteen rows and two columns, each array having 128K memory cells. Only the first five and the last four of the rows are shown, the remaining seven middle rows being similar in construction and indicated by dashed continuation lines. The arrays 26 are spaced from each other in a vertical or columnar direction by respective ones of a plurality of sense amplifiers 28 and in a row or horizontal direction by a vertical space indicated generally at 30.

The vertical space 30 is in part occupied by a plurality of row decoder sections 32. The layout of the arrays 26, sense amplifiers 28 and row decoder sections 32 leaves a plurality of "holes" 34 that are used to lay out the predecoders and row redundancy decoders described below. The drive/boot signal line 22 and the row factor signal lines 24 are preferably routed down the length of the chip within the vertical space 30.

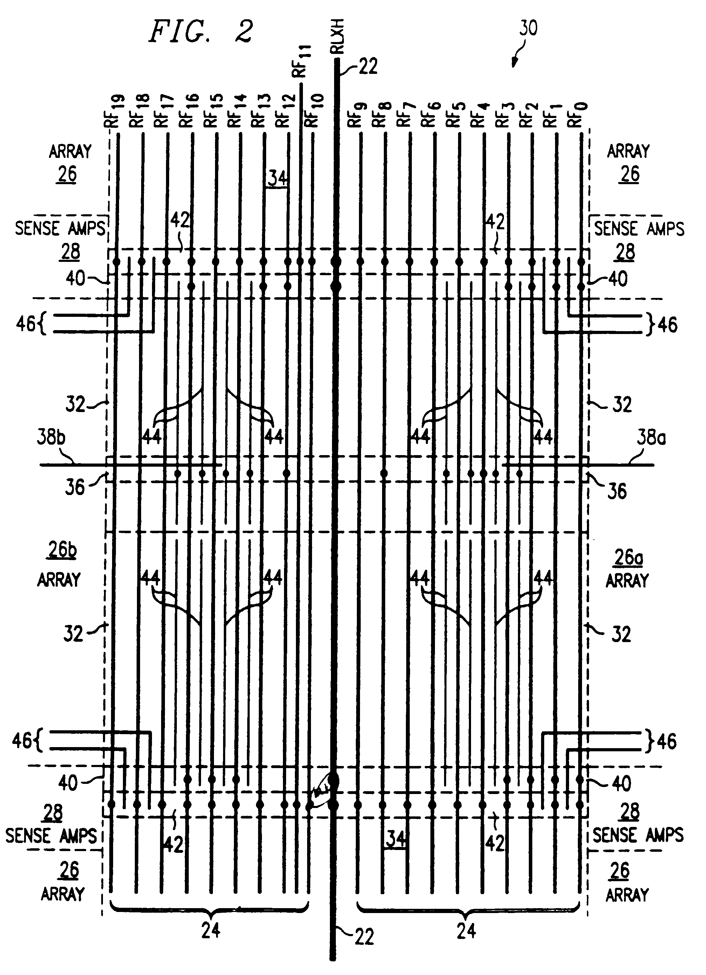

Turning now to FIGURE 2, a small detail of the layout shown in FIGURE 1 is illustrated. The areas devoted to laying out cell arrays 26, sense amplifiers 28, decoder sections 32, and the predecoders and row redundancy decoders described below are indicated by dashed lines. The row decoder sections 32 are preferably laid out in pairs back-to-back and extend across the vertical space 30 from one cell array 26a in the right column to the opposite cell array 26b in the left column. In the illustrated embodiment, there are thirty-two row decoders in each row decoder section 32, one such row decoder being indicated at 36, surrounded by a dashed enclosure. Each row decoder 36 is operable to decode the drive/boot signal line onto two of eight word lines, four of the word lines being disposed in the cell array 26a and the other four row lines being disposed in the cell array 26b. Two of these word lines are shown at 38a, 38b.

A predecoder 40 is preferably laid out to be adjacent a respective decoder section 32. Predecoders 40 are laid out to use at least some of the space provided by "holes" 34. Each decoder section 32 is further provided with a row redundancy decoder 42 that is preferably disposed in an area adjacent to a respective predecoder 40.

The drive/boot signal (RLXH) generator line 22 is constituted by a relatively wide conductor strap in second metal to minimize resistance and preferably runs down the middle of the vertical space 30. Line 22 is connected to each row redundancy decoder 42 and each predecoder 40 along the length of the chip, as shown schematically by the connection dots on line 22.

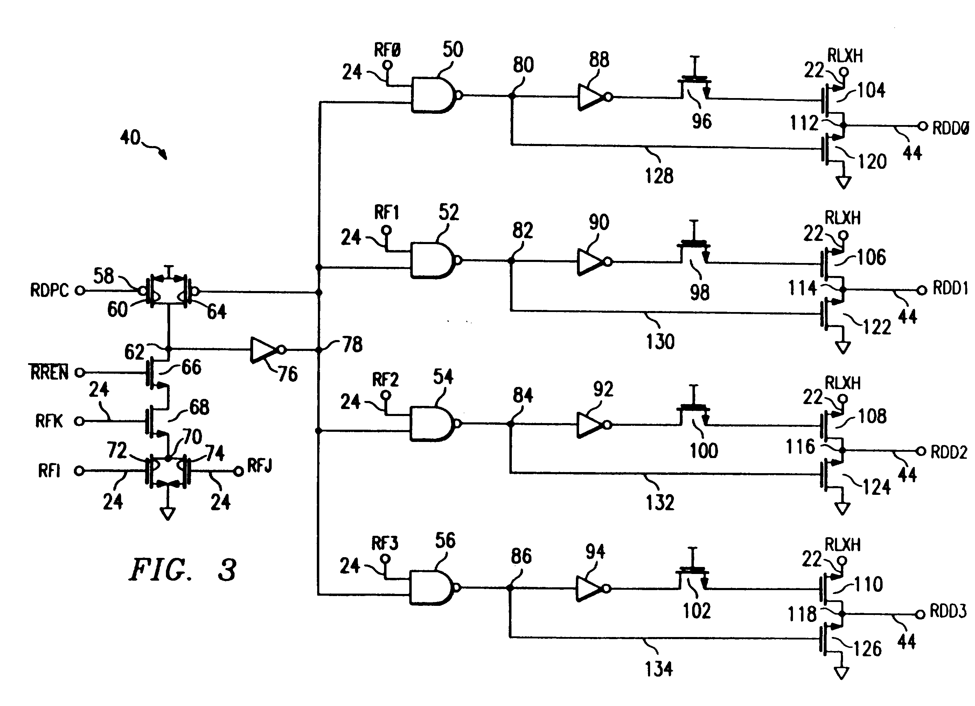

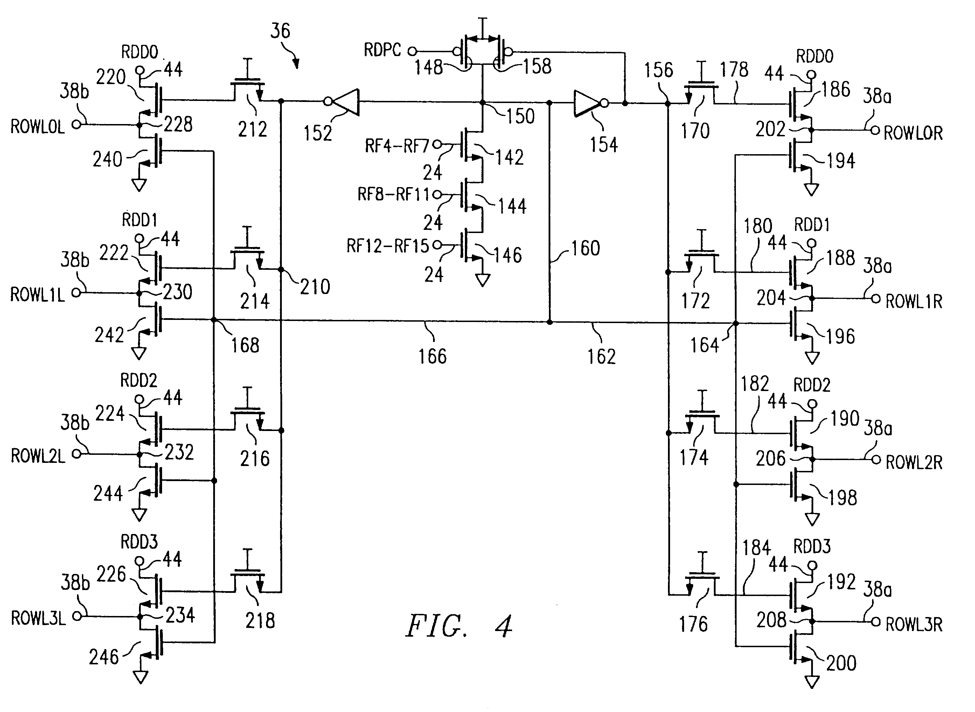

The row factor (RF) signal lines 24 are routed generally in parallel to the RLXH signal line 22. Each of the twenty row factor signal lines 24 are connected to each row redundancy decoder 42, but only selected ones of the row factor signal lines 24 are connected to any one of the predecoders 40 and the decoders 36. The row factor signal lines 24 are connected to a particular predecoder 40 or to a particular decoder 36 according to a decoding scheme described more particularly in conjunction with FIGURES 3 and 4.

A plurality of predecoder lines 44 originate within the predecoder 40 and are disposed generally in parallel with the row factor signal lines 24. The predecoder lines 44 are preferably formed in second metal where they are parallel to row factor lines 24, and in first metal when they run perpendicular thereto (not shown in this schematic representation). Each predecoder line 44 intersects and is connected with each decoder 36 in a respective decoder section 32. In the illustrated embodiment, there are four predecoder output lines 44 and the signals carried thereon are termed RDD0, RDD1, RDD2, and RDD3 (see FIGURE 3).

In the illustrated embodiment, each row redundancy decoder 42 is operable to decode the drive/boot signal onto a selected two of four redundant row lines 46. Four redundant row lines 46 are provided to replace up to two pairs of regular row lines 38 as needed. The row redundancy scheme herein mentioned is more particularly described in co-pending application Serial No. _____ (Attorney's Docket Number TI-12989).

Turning now to FIGURE 3, there is illustrated a detailed electrical schematic diagram of one of the predecoders 40. A plurality of selected row factor lines 24 are connected as inputs to the predecoder circuit 40, and their identity varies according to a predetermined decoding scheme. Row factor lines RF0 - RF3 are connected to respective inputs of four NAND gates 50-56. Row factor signal lines RF0 - RF3 are connected to each predecoder circuit 40 on the chip. On the other hand, the identity of three other row factor signal input lines RFI, RFJ and RFK vary according to the particular predecoder circuit 40 to which they are connected. The table below gives the identity of RFI, RFJ and RFK according to the cardinal number of the particular predecoder 40.

TABLE I

| Predecoder No. | RFI | RFJ | RFK |
|---|---|---|---|
| 0, 8, 16, 24 | RF12 | RF13 | RF16 |
| 1, 9, 17, 25 | RF14 | RF15 | RF16 |
| 2, 10, 18, 26 | RF12 | RF13 | RF17 |
| 3, 11, 19, 27 | RF14 | RF15 | RF17 |
| 4, 12, 20, 28 | RF12 | RF13 | RF18 |
| 5, 13, 21, 29 | RF14 | RF15 | RF18 |
| 6, 14, 22, 30 | RF12 | RF13 | RF19 |
| 7, 15, 23, 31 | RF14 | RF13 | RF19 |

Seven row factor signal lines thus make connection to the inputs of each predecoder 40, while the remaining thirteen do not.

A predecoder signal output precharge signal RDPC is connected to a gate 58 of a P-channel transistor 60. The current path of transistor 60 selectively connects a voltage supply source ($V_{dd}$) to a node 62. The current path of another P-channel transistor 64 is also operable to connect $V_{dd}$ to the node 62.

The drain of an N-channel transistor 66 is connected to the node 62, while a source thereof is connected to the drain of a further N-channel transistor 68. The source of the N-channel transistor 68 is connected to a node 70, which in turn is connected to the drains of two N-channel transistors 72 and 74. The sources of N-channel transistors 72 and 74 are connected to ground or $V_{ss}$. The row factor signal line RFK is connected to the gate of transistor 68. The gate of transistor 72 is connected to signal line RFI, while the gate of transistor 74 is connected to signal line RFJ. The gate of transistor 66 is connected to a row redundancy enable signal line $\overline{RREN}$.

Node 62 serves as the input to an inverter 76. The output of inverter 76 is connected to a node 78, which in turn is connected back to the gate of the P-channel transistor 64. Node 78 is also connected to second inputs of NAND gates 50-56.

The outputs of NAND gates 50-56 are connected to respective nodes 80, 82, 84 and 86. Each node 80-86 is connected to an input of a respective inverter 88-94. The output of each inverter 88-94 is connected to the source of a respective large pass gate transistor 96-102. Each of the pass gate transistors 96-102 has a gate thereof connected to $V_{dd}$.

The source of each pass gate transistor 96, 98, 100 and 102 is connected to the gate of a respective N-channel transistor 104, 106, 108 or 110. The sources of each of the transistors 104-110 are connected to the drive/boot signal line 22 (RLXH). The drains of transistors 104-110 are connected to respective nodes 112, 114, 116 and 118. Each node 112-118 is connected to the source of a respective grounding transistor 120, 122, 124 or 126. The drains of the grounding transistors 120-126 are connected to ground or $V_{ss}$. The gates of each transistor 120-126 are connected by respective lines 128-134 back to respective nodes 80-86. Each node 112-118 is connected to a respective predecoder output line RDD0-RDD3.

Turning next to FIGURE 4, a detailed schematic diagram of one decoder circuit 36 is illustrated. Decoder circuit 36 is enabled by high states of three row factor signals appearing on the respective gates of enabling transistors 142, 144 and 146 in the center of FIGURE 3. The RF line 24 connected to the gate of transistor 142 is selected from one of RF4 through RF7. Similarly, the RF signal line connected to the gate of transistor 144 is selected from RF8 through RF11, and the row factor signal line 24 that is connected to the gate of transistor 146 is selected from RF12 through RF15. The selection as to which of these lines is connected to the particular decoder circuit 36 varies according to the identity of the particular decoder circuit 36 within the decoder section 32 (FIGURE 2). In this way, one out of the thirty-two decoders within any decoder section 32 can be selected.

A row decoder precharge signal line RDPC is connected to the gate of a P-channel transistor 148. The current path of transistor 148 connects a voltage supply $V_{dd}$ to a node 150. Node 150 is connected to the inputs of left and right inverters 152 and 154. The output of inverter 154 is connected to a node 156, which is in turn connected back to the gate of a P-channel transistor 158. The current path of transistor 158 connects a $V_{dd}$ voltage supply to node 150. Node 150 is connected through lines 160 and 162 to a node 164, and is further connected through lines 160 and 166 to a node 168. Node 150 is selectively connected through the current paths of selecting transistors 142, 144 and 146 to $V_{ss}$ or ground.

Right inverter output node 156 is connected to the sources of each of four pass transistors 170, 172, 174 and 176. The drains of transistors 170-176 are in turn respectively connected to lines 178, 180, 182 and 184. Lines 178-184 are in turn connected to the gates of respective self-booting decoding transistors 186, 188, 190 and 192.

Node 164 is connected to the gate of each of four row line grounding transistors 194, 196, 198 and 200. Grounding transistors 194-200 are operable to connect respective word line nodes 202, 204, 206 and 208 to ground. Each row line node 202-208 is connected to a respective right array row line ROWL0R, ROWL1R, ROWL2R, or ROWL3R.

The decoding circuitry for the left array is similar to that for the right array. An output node 210 of left inverter 152 is connected to the source of each of a plurality of pass gate transistors 212, 214, 216 and 218. The drain of each of the pass gate transistors 212-218 is connected to a gate of a respective self-booting decoding transistor 220, 222, 224 or 226. The current path of each decoding transistor 220-226 connects a respective predecoder output line RDD0-RDD3 to a respective left array row line node 228, 230, 232 or 234. The left array row lines ROWL0L, ROWL1L, ROWL2L and ROWL3L are connected to the respective left array row line nodes 28-234.

The decoding of a drive/boot signal onto selected ones of the left and right row lines is as follows. Referring again to FIGURE 1, a plurality of row factor signals are generated by the row factor signal generator 18 in the peripheral area 14. These travel by selected row factor lines 24 to each decoder and predecoder on the chip 10. High row factor signal states will be generated on one of lines RF0-RF3, one of lines RF4-RF7, one of lines RF8-RF11, one of lines RF12-RF15, and one of lines from RF16-19. Turning now to FIGURE 3 and as shown by Table I set out above, either RFI OR RFJ of certain selected predecoder circuits 40 will be on so that either the gate of transistor 72 or the gate of transistor 74 will be turned on.

Turning back momentarily to FIGURE 1, the architecture of the DRAM illustrated is divided into four quadrants, and the decoding scheme is such that one predecoder will be selected for each quadrant out of the the eight predecoders in the quadrant. A DRAM according to the invention could also be divided into halves, octants, or any other portions containing an integral quotient of the total number of predecoders.

With reference to FIGURE 3, this means that for the selected predecoders, RFK and one RFI or RFJ will be in the high state, while the remaining seven of the eight predecoders in the quadrant will not have this enabling combination. The signal $\overline{RREN}$ must also be high to prevent the disabling of the entire predecoder. Finally, the precharge signal RDPC must go high to switch off P-channel transistor 58 so that node 62 can be pulled low. In each of the selected predecoders 40, the low state of node 62 will be inverted to a high state on node 78, which in turn will enable each of the NAND gates 50-56. Only one of the row factor signals RF0-RF3 will be high, while the rest will be low. Therefore, a selected one of the NAND gate output nodes 80-86 will be low, for example, node 82. The low state at node 82 will be inverted by inverter 90 to a high state at the drain of the transistor 98. Transistor 98 is operable to transfer this high state, minus a $V_t$ drop, to the gate of the respective decoding transistor 106.

Referring briefly back to FIGURE 1, a drive signal RLXH will be sent down the drive/boot signal line 22 from the peripheral area 14 into the cell array area 12. Referring back to FIGURE 3, the (in this example) turned-on decoding transistor 106 will self-boot its gate to above $V_{dd}+V_t$, as both node RLXH and node 114 rise, thus allowing a full $V_{dd}$ to appear at node 114, which in turn is output on the RDD1 predecoder output line.

Referring now to FIGURE 4, RDD1 appears at the drains of both the left decoding transistor 222 and right decoding transistor 188. The RF signals sent down the length of the chip from the RF signal generator 18 (FIGURE 1) will have selected one out of thirty-two decoders 36 in each decoding section 32 on the chip. The combination of selecting one out of eight predecoders 40 in each quadrant, one RDD line out of four RDD lines per predecoder 40, and one decoder 36 out of thirty-two decoders 36 (FIGURE 2) per predecoder 40, means that only two row lines will be active per quadrant. In addition, the parasitic capacitance of only sixty-four decoding transistors of the thirty-two decoders 36 per quadrant is seen by the RLXH drive/boot signal, as the parasitic capacitance of the remaining one hundred and ninety-two decoding transistors of the thirty-two decoders 36 is masked by the nonselected parts of the selected predecoders 40, in other words, the three nonactive RDD lines. All of the parasitic capacitance of the other decoding transistors in the quadrant are masked from the RLXH drive/boot signal by the nonselected predecoders 40 in the quadrant.

A low state at the decoder selecting node 150 in a selected decoder 36 (FIGURE 4) will be inverted by the inverters 152 and 154 and will therefore appear as high states at nodes 156 and 210. The high states at nodes 156 and 210 are passed through the transistors 170, 172, 174, 176, 212, 214, 216, and 218 to actuate the gates of right decoding transistors 186-192 and left decoding transistors 220-226. However, this results in a $V_t$ drop across transistors 170-176 and 212-218 as the gates of transistors 186-192 and 220-226 are charged to $V_{dd}$-$V_t$. The high state at the inverter output node 156 will also turn off the precharging transistor 158. The precharging transistor 148 will be turned off by a high state of RDPC.

In the case of the nonselected decoders 36, the state at node 150 will be high. This high state is communicated through lines 160, 162 and 166 to the gates of each of the right and left row line discharge transistors 194, 196, 198, 200, 240, 242, 244 and 246. Therefore, the right row line nodes 202-208 and the left row lines nodes 228-234 will stay discharged.

Assuming that node 150 is high, however, each of the current paths of transistors 186-192 and 220-226 will be actuated to transmit a high state appearing on any of the predecoder output lines RDD0 - RDD3 to an appropriate set of right and left row lines. Carrying through the example that RDD1 is high and RDD0, RDD2, and RDD3 are low, the high RDD1 signal would be transmitted through the current path of transistors 188 and 222 to respective left and right row line nodes 230 and 204, which self-boot the gate of transistors 188 and 222 to at least $V_{dd}$+$V_t$, disallowing any $V_t$ drop across transistors 188 and 222. Transmission lines ROWL1R and ROWL1L would thereby be driven by the drive signal RLXH. This same current path established by the decoding of the predecoder circuit 40 (FIGURE 3) and the decoder circuit 36 (FIGURE 4) is used for the booting signal subsequently transmitted by the drive/boot generator to ROWL1R and ROWL1L during an active restore portion of the DRAM cycle.

In summary, a two-tier decoding scheme has been disclosed that prevents the drive/boot signal from "seeing" the parasitic capacitance of all but a small number of decoder circuits. Since the predecoder circuits are disposed locally on the chip, a global drive/boot signal line can be used without excessive power dissipation.

While a preferred embodiment and its advantages have been described in the above detailed description, the invention is not limited thereto but only by the scope of the appended claims.

**Claims**

1. A memory device comprising a cell array area (12) comprising integrated circuit memory arrays (26) each having a plurality of row lines and a decoding circuit for driving said row lines (36a, 38b) comprising:

   a generator (20) for generating a drive signal (RLXH);

   a plurality of decoders (36) formed in said cell array area (12);
   a respective plurality (38a, 38b) of said row lines being coupled to each decoder (36), and at least an addressed one of said decoders (36) being operable to transmit a decoded drive signal (ROWL0R, ROWL1R, ROWL2R, ROWL3R, ROWL0L, ROWL1L, ROWL2L and ROWL3L) to at least one of said row lines (38a, 38b);
   a drive signal line (22) for carrying said drive signal (RLXH) generated by said generator (20), said drive signal line (22) being connected to a plurality of predecoders (40) formed in said cell array area (12),
   for each predecoder (40) there being an associated plurality of said decoders (36) formed in said cell array area (12),and one (RDD0, RDD1, RDD2, RDD3) of a plurality (44) of outputs of at least an addressed one of said plurality of predecoders (40) being operable to transmit a predecoded drive signal (RDD0, RDD1,...) to each of said associated plurality (32) of said decoders (36); and
   an addressing signal generator (18) formed in a peripheral area (14) and coupled to each of said predecoders (40) and to each of said decoders (36) for transmitting addressing signals (24) thereto;

   each predecoder (40) having a plurality of predecoder outputs (44), and each predecoder (40) being operable to decode said drive signal onto one (RDD0, RDD1, RDD2, RDD3) of said predecoder outputs (44) in response to a respective predetermined combination of said addressing signals;
   said decoders (36) being coupled to said addressing signal generator (18) for receiving addressing signals therefrom, and each decoder (36) being operable to decode a predecoded drive signal received on one of said predecoder outputs (44) to at least a pre-selected one of said plurality of row lines in response to receiving a predetermined combination of said addressing signals;
   characterized in that the addressing signal generator (18) is operable to generate a plurality of row factor signals (RF) based on a received external address; and in that
   a set (RF0, RF1, RF2, RF3) of said row factor signals (RF) is operable to select said one (RDD0, RDD1, RDD2, RDD3) of said predecoder outputs (44) for transmitting said predecoded drive signal thereon.

2. A memory device as claimed in claim 1 and wherein a further set (RFI, RFJ, RFK) of said row factor signals (RF) is operable to enable said addressed predecoder (40) to predecode said drive signal onto said one (RDD0, RDD1, RDD2, RDD3) of said predecoder outputs (44).

3. A memory device of claim 2, wherein said further set (RFI, RFJ, RFK) of row factor signals (RF) is transmitted to said predecoders (40) on respective row factor lines (24), said further set (RFI, RFJ, RFK) comprising a plurality of subsets, each predecoder (40) being coupled to a row factor line (24) corresponding to a row factor signal from each of said subsets.

4. A memory device of claim 1, claim 2 or claim 3, wherein each decoder (36) is coupled to selected ones of said plurality of row factor lines (24) carrying respective row factor signals (RF), an integral number of row lines (ROW) corresponding to each of said predecoder outputs (RDDO, RDD1, RDD2, RDD3, 44) being coupled to said decoder (36), said decoder (36) being operable to decode a drive signal from one of said predecoder outputs (RDDO, RDD1, RDD2, RDD3, 44) to one of said corresponding row lines (ROW) in response to receiving predetermined signals from said selected ones of said row factor lines (24).

5. A memory device of claim 1, claim 2 or claim 3, wherein each decoder (36) is operable to decode a predecoded signal from an output (RDDO, RDD1, RDD2, RDD3, 44) of a respective predecoder (40) onto a respective two of said row lines coupled thereto.

6. A memory device as claimed in any preceding claim, comprising:

a plurality of said memory arrays (26) of memory cells formed at a face of a semiconductor layer within the cell array area (12) of said device, said memory arrays (26) formed in a plurality of parallel rows and columns;
a plurality of said decoder sections (32), each array (26) spaced from a next adjacent array (26) in a row direction by at least one of said decoder sections (32);
wherein said predecoders (40) are formed in said array area (12), each predecoder (40) being formed proximate a respective one of the decoder sections (32);
for each array (26), a plurality of said decoders (36) is formed within a respective one of the decoder sections (32) adjacent said array (26), a plurality of said row lines (38a, 38b) is formed within each array (26) and coupled to said decoders (36), each decoder (36) being operable to drive an addressed one of said row lines (38a, 38b);
the row factor signal generator (18) being formed at said face, said row factor signals (RF) being operable to actuate an integral quotient of said predecoders (40) and at least one decoder (36) in each decoder section (32) to decode said drive signal onto a number of said row lines (38a, 38b) equal to an integral multiple of said quotient.

7. A memory device as claimed in claim 6 wherein the plurality of row factor lines (24) are formed generally in parallel in a column direction and coupled to said row factor signal generator (18);and
for each predecoder (40) the plurality of predecoder lines are coupled to outputs (RDDO, RDD1, RDD2, RDD3, 44) thereof and coupled to each decoder (36) in a corresponding decoder section (32).

8. The memory device of claim 6 or 7, wherein said memory array columns comprise a left column and a right column, a vertical space (30) separating said left column from said right column, each memory array (26b) in said left column having a corresponding memory array (26a) in said right column, said memory arrays (26) having a width in said column direction;

for each row of said memory arrays (26), two of said decoder sections (32) are disposed in said vertical space (30) to extend from said left memory array (26b) to said right memory array (26a) and adjacent each other;
said drive signal line (22) is routed through said vertical space (30) between said arrays (26) to connect to each of said predecoders (40).

9. The memory device of claim 8 wherein the plurality of row factor lines (24) are routed generally in parallel within said vertical space (30).

**Patentansprüche**

1. Speichervorrichtung mit einem Zellenmatrixbereich (12), der als integrierte Schaltung ausgeführte Speichermatrizen (26) mit jeweils mehreren Zeilenleitungen umfaßt, sowie mit einer Decodierschaltung zum Ansteuern der Zeilenleitungen (38a, 38b), enthaltend:

einen Generator (20) zum Erzeugen eines Ansteuersignals (RLXH);

mehrere Decodierer (36), die in dem Zellenmatrixbereich (12) gebildet sind;

wobei jeweils mehrere (38a, 38b) der Zeilenleitungen mit jedem Decodierer (36) gekoppelt sind und wenigstens ein adressierter dieser Decodierer (36) ein decodiertes Ansteuersignal (ROWL0R, ROWL1R, ROWL2R, ROWL3R, ROWL0L, ROWL1L, ROWL2L und ROWL3L) zu wengistens einer der Zeilenleitungen (38a, 38b) übertragen kann;

eine Ansteuersignalleitung (22) zum Übertragen des von dem Generator (20) erzeugten Ansteuersignals (RLXH), wobei die Ansteuersignalleitung (22) an mehrere in dem Zellenmatrixbereich (12) gebildete Vordecodierer (40) angeschlossen ist,

wobei für jeden Vordecodierer (40) eine zugeordnete Anzahl der in dem Zellenmatrixbereich (12) gebildeten Decodierer (36) vorgesehen ist und einer (RDD0, RDD1, RDD2, RDD3) einer Anzahl (44) von Ausgängen wenigstens eines adressierten der mehreren Vordecodierer (40) ein vordecodiertes Ansteuersignal (RDD0, RDD1, RDD2, RDD3) zu jeder der zugeordneten Anzahl (32) der Decodierer (36) übertragen kann; und

einen Adressierungssignalgenerator (18), der in einem peripheren Bereich (14) gebildet und mit jedem der Vordecodierer (40) sowie jedem der Decodierer (36) gekoppelt ist, um zu diesen Adressierungssignale (24) zu übertragen;

wobei jeder Vordecodierer (40) mehrere Vordecodiererausgänge (44) aufweist und jeder Vordecodierer (40) das Ansteuersignal auf einen (RDD0, RDD1, RDD2, RDD3) der Vordecodiererausgänge (44) abhängig von einer jeweiligen vorbestimmten Kombination der Adressierungssignale übertragen kann;

wobei die Decodierer (36) mit dem Adressierungssignalgenerator (18) gekoppelt sind, um von diesem Adressierungssignale zu empfangen, und wobei jeder Decodierer (36) ein an einem der Vordecodiererausgänge (44) empfangenes vordecodiertes Ansteuersignal wengistens einer vorgewählten der mehreren Zeilenleitungen in Abhängigkeit vom Empfang einer vorbestimmten Kombination der Adressierungssignale decodieren kann;

dadurch gekennzeichnet, daß der Adressierungssignalgenerator (18) mehrere Zeilenfaktorsignale (RF) auf der Basis einer empfangenen externen Adresse erzeugen kann; und daß eine Gruppe (RF0, RF1, RF2, RF3) der Zeilenfaktorsignale (RF) einen (RDD0, RDD1, RDD2, RDD3) der Vordecodiererausgänge (44) auswählen kann, um an ihn das vordecodierte Ansteuersignal zu übertragen.

2. Speichervorrichtung nach Anspruch 1, bei welcher eine weitere Gruppe (RFI, RFJ, RFK) der Zeilenfaktorsignale (RF) den adressierten Vordecodierer (40) für das Vordecodieren des Ansteuersignals auf einen (RDD0, RDD1, RDD2, RDD3) der Vordecodiererausgänge (44) freigeben kann.

3. Speichervorrichtung nach Anspruch 2, bei welcher die weitere Gruppe (RFI, RFJ, RFK) der Zeilenfaktorsignale (RF) zu den Vordecodierern (40) auf jeweiligen Zeilenfaktorleitungen (24) übertragen wird, wobei die weitere Gruppe (RFI, RFJ, RFK) mehrere Untergruppen umfaßt, wobei jeder Vordecodierer (40) entsprechend einem Zeilenfaktorsignal aus jeder Untergruppe an eine Zeilenfaktorleitung (24) angeschlossen ist.

4. Speichervorrichung nach Anspruch 1, Anspruch 2 oder Anspruch 3, bei welcher jeder Decodierer (36) mit aus den mehreren Zeilenfaktorleitungen (24) ausgewählten Zeilenfaktorleitungen verbunden ist, die jeweilige Zeilenfaktorsignale (RF) zu führen, wobei eine ganze Anzahl von Zeilenleitungen (ROW) entsprechend jedem der Vordecodiererausänge (RDD0, RDD1, RDD2, RDD3, 44) mit dem Decodierer (36) verbunden ist, wobei der Decodierer (36) ein Ansteuersignal von einem der Vordecodiererausgänge (RDD0, RDD1, RDD2, RDD3, 44) auf eine der entsprechenden Zeilenleitungen (ROW) abhängig vom Empfang vorbestimmter Signale von den aus den Zeilenfaktorleitungen (24) ausgewählten Zeilenfaktorleitungen decodieren kann.

5. Speichervorrichtung nach Anspruch 1, Anspruch 2 oder Anspruch 3, bei welcher jeder Decodierer (36) ein vordecodiertes Signal von einem Ausgang (RDD0, RDD1, RDD2, RDD3, 44) eines jeweiligen Vordecodierers (40) auf jeweils zwei der mit ihm verbundenen Zeilenleitungen decodieren kann.

6. Speichervorrichtung nach einem der vorherigen Ansprüche, enthaltend:

mehrere Speichermatizen (36) aus Speicherzellen, die an einer Fläche einer Halbleiterschicht innerhalb des Zellenmatrixbereichs (12) der Vorrichtung gebildet sind, wobei die Speichermatrizen (26) in mehreren parallelen Zeilen und Spalten gebildet sind;

mehrere Decodiererabschnitte (32), wobei jede Matrix (26) um wenigstens einen der Decodiererabschnitte (32) in Zeilenrichtung im Abstand von einer nächsten benachbarten Matrix (26) liegt;

wobei die Vordecodierer (40) in dem Matrixbereich (12) gebildet sind, wobei jeder Vordecodierer (40) angrenzend an einen der Decodiererabschnitt (32) gebildet ist;

wobei für jede Matrix (26), angrenzend an diese Matrix (26) mehrere Decodierer (36) innerhalb jeweils eines der Decodiererabschnitte (32) gebildet sind, wobei innerhalb jeder Matrix (26) mehrere, mit den Decodierern (36) verbundene Zeilenleitungen (38a, 38b) gebildet sind, wobei jeder Decodierer (36) eine adressierte dieser Zeilenleitungen (38a, 38b) ansteuern kann;

wobei der Zeilenfaktorsignalgenerator (18) an der Fläche gebildet ist, wobei die Zeilenfaktorsignale (RF) einen ganzzahligen Quotienten der Vordecodierer (40) und wenigstens einen Decodierer (36) in jedem Decodiererabschnitt (32) betätigen können, um das Ansteuersignal auf eine Anzahl der Zeilenleitungen (38a, 38b) decodieren kann, die gleich einem ganzzahligen Vielfachen dieses Quotienten ist.

7. Speichervorrichtung nach Anspruch 6, bei welcher die Zeilenfaktorleitungen (24) allgemein parallel in einer Spaltenrichtung gebildet und mit dem Zeilenfaktorsignalgenerator (18) verbunden sind; und wobei für jeden Vordecodierer (40) die Anzahl der Vordecodiererleitungen mit Ausgängen (RDD0, RDD1, RDD2, RDD3, 44) und mit jedem Decodierer (36) in einem entsprechenden Decodiererabschnitt (32) verbunden sind.

8. Speichervorrichtung nach Anspruch 6 oder 7, bei welcher die Speichermatrixspalten eine linke Spalte und eine rechte Spalte umfassen und ein vertikaler Abstand (30) die linke Spalte von der rechten Spalte trennt, wobei jede Speichermatrix (26b) in der linken Spalte eine entsprechende Speichermatrix (36a) in der rechten Spalte hat, wobei die Speichermatrizen (26) in der Spaltenrichtung eine Breite haben;

wobei für jede Zeile der Speichermatrizen (26) zwei der Decodiererabschnitte (32) in dem vertikalen Abstand (30) so angeordnet sind, daß sie sich von der linken Speichermatrix (26b) aneinander angrenzend zur rechten Speichermatrix (26a) erstrecken;

wobei die Ansteuersignalleitung (22) durch den vertikalen Abstand (30) zwischen den Matrizen (26) zum Anschluß an jeden der Vordecodierer (40) geführt ist.

9. Speichervorrichtung nach Anspruch 8, bei welcher die mehreren Zeilenfaktorleitungen (24) innerhalb des vertikalen Abstandes (30) allgemein parallel geführt sind.

**Revendications**

1. Dispositif de mémoire comportant une zone (12) de réseaux de cellules comprenant des réseaux de mémoire à circuits intégrés (26) possédant chacun une pluralité de conducteurs de lignes et un circuit de décodage pour la commande desdits conducteurs de lignes (38a, 38b), comprenant :

un générateur (20) servant à produire un signal de commande (RLXH);
une pluralité de décodeurs (36) formés dans ladite zone (12) de réseaux de cellules;

une pluralité respective (38a, 38b) desdits conducteurs de lignes étant couplée à chaque décodeur (36) et au moins l'un adressé desdits décodeurs (36) pouvant fonctionner de manière à transmettre un signal de commande décodé (ROWLOR, ROWL1R, ROWL2R, R0WL3R, ROWLOL, ROWL1L, ROWL2L et ROWL3L) à au moins un desdits conducteurs de lignes (38a, 38b);

un conducteur (22) de transmission d'un signal de commande pour véhiculer ledit signal de commande (RLXH) produit par ledit générateur (20), ledit conducteur (22) de transmission du signal de commande étant connectée à une pluralité de prédécodeurs (40) formés dans ladite zone (12) de réseaux de cellules,
une pluralité associée desdits décodeurs (36) formés dans ladite zone (12) de réseaux de cellules pour chaque prédécodeur (40), et l'une (RDD0, RDD1, RDD2, RDD3) d'une pluralité (44) de sorties d'au moins un prédécodeur adressé parmi la pluralité de prédécodeurs (40) pouvant agir de manière à transmettre un signal de commande prédécodé (RDD0, RDD1, RDD2, RDD3) à chaque décodeur de ladite pluralité associée (32) desdits décodeurs (36); et
un générateur de signaux d'adressage (18) formé dans une zone périphérique (14) et couplé à chacun desdits prédécodeurs (40) et à chacun desdits décodeurs (36) pour lui transmettre des signaux d'adressage (24); chaque prédécodeur (40) possédant une pluralité de sorties (44), et chaque prédécodeur (40) pouvant agir de manière à décoder ledit signal de commande appliqué sur l'une (RDD0, RDD1, RDD2, RDD3) desdites sorties (44) des précodeurs en réponse à une combinaison respective prédéterminée desdits signaux d'adressage;
lesdits décodeurs (36) étant couplés audit générateur de signaux d'adressage (18) pour la réception de signaux d'adressage de la part de ce générateur et chaque décodeur (36) pouvant agir de manière à décoder un signal de commande prédécodé reçu sur l'une desdites sorties (44) des prédécodeurs à au moins un conducteur présélectionné parmi ladite pluralité de conducteurs de lignes en réponse à la réception d'une combinaison prédéterminée desdits signaux d'adressage;

caractérisé en ce que le générateur (18) de signaux d'adressage peut agir de manière à produire une pluralité de signaux de facteurs de lignes (RF) sur la base d'une adresse externe reçue; et en ce

qu'un ensemble (RF0,RF1,RF2,RF3) desdits signaux de facteurs de lignes (RF1) peut agir de manière à sélectionner ladite sortie (RDD0,RDD1,RDD2,RDD3) parmi lesdites sorties (44) des prédécodeurs pour transmettre ledit signal de commande prédécodé à cette sortie.

2. Dispositif de mémoire selon la revendication 1, caractérisé en ce qu'un ensemble additionnel (RFI, RFJ, RFK) desdits signaux de facteurs de lignes (RF) est à même de valider ledit prédécodeur adressé (40) pour prédécoder ledit signal de commande sur ladite sortie (RDD0, RDD1, RDD2, RDD3) desdites sorties (44) des prédécodeurs.

3. Dispositif de mémoire selon la revendication 2, dans lequel ledit second ensemble additionnel (RFI, RFJ, RFK) de signaux de facteurs de lignes (RF) est transmis auxdits prédécodeurs (40) dans des conducteurs respectifs (24) de transmission des facteurs de lignes, ledit ensemble additionnel (RFI, RFJ, RFK) comprenant une pluralité de sous-ensembles, chaque prédécodeur (40) couplé à un conducteur (24) de transmission d'un facteur de ligne correspondant à un signal de facteur de ligne provenant de chacun desdits sous-ensembles.

4. Dispositif de mémoire selon l'une des revendications 2 et 3, dans lequel chaque décodeur (36) est couplé à des conducteurs sélectionnés parmi une pluralité de conducteurs (24) de transmission de facteurs de lignes, véhiculant respectivement des signaux de facteurs de lignes (RF), un nombre entier de conducteurs de lignes (ROW) correspondant à chacune desdites sorties (RDD0, RDD1, RDD2, RDD3, 44) des prédécodeurs est couplé audit décodeur (36), et ledit décodeur (36) peut agir de manière à décoder un signal de commande provenant de l'une desdites sorties (RDD0, RDD1, RDD2, RDD3, 44) des prédécodeurs reliés à l'un desdits conducteurs de lignes correspondants (ROW) en réponse à la réception de signaux prédéterminés à partir desdits conducteurs sélectionnés parmi lesdits conducteurs (24) de transmission de facteurs de lignes.

5. Dispositif de mémoire selon l'une quelconque des revendications 1, 2 et 3, dans lequel chaque décodeur (36) peut agir de manière à décoder un signal prédécodé provenant d'une sortie (RDD0, RDD1, RDD2, RDD3, 44) d'un prédécodeur respectif (40) dans deux conducteurs respectifs parmi lesdits conducteurs de lignes, qui sont couplés au décodeur.

6. Dispositif de mémoire selon l'une quelconque des revendications précédentes, comprenant :

une pluralité desdits réseaux de mémoire (26) de cellules de mémoire formées sur une face d'une couche semiconductrice à l'intérieur de la zone (12) de réseaux de cellules dudit dispositif, lesdits réseaux de mémoire (26) étant formés suivant une pluralité de lignes parallèles et de colonnes parallèles;
une pluralité desdites sections (32) de décodeurs, chaque réseau (26) étant séparé d'un réseau adjacent suivant (26) dans une direction de ligne par au moins l'une desdites sections (32) de décodeurs;
dans lequel lesdits prédécodeurs (40) sont formés dans ladite zone (12) de réseaux, et chaque prédécodeur (40) étant formé à proximité de l'une respective des sections (32) de décodeurs;
pour chaque réseau (26), une pluralité desdits décodeurs (26) est formée à l'intérieur de l'une respective des sections (32) de décodeurs au voisinage dudit réseau (26), et une pluralité desdits conducteurs de lignes (38a,38b) est formée dans chaque réseau (26) et est couplée auxdits décodeurs (36), chaque décodeur (36) pouvant agir de manière à commander l'un adressé desdits conducteurs de lignes (38a, 38b); et
le générateur (18) de signaux de facteurs de lignes étant formé au niveau de ladite face, lesdits signaux de facteurs de lignes (RF) pouvant agir de manière à activer une fraction entière desdit prédécodeurs (40) et au moins un décodeur (36) dans chaque section (32) de décodeurs pour décoder ledit signal de commande dans un certain nombre desdits conducteurs de lignes (38a,38b), égal à un multiple entier de ladite fraction.

7. Dispositif de mémoire selon la revendication 6, dans lequel la pluralité de conducteurs (24) de transmission de facteurs de lignes sont formés d'une manière générale parallèlement à une direction de colonnes et sont couplés audit générateur (18) de signaux de facteurs de lignes; et

pour chaque prédécodeur (40), la pluralité de conducteurs du prédécodeur sont couplés à des sorties (RDD0, RDD1, RDD2, RDD3, 44) de ce décodeur et sont couplées à chaque décodeur (36) dans une section correspondante (32) de décodeurs.

8. Dispositif de mémoire selon la revendication 6 ou 7, dans lequel lesdites colonnes du réseau de mémoire comprennent une colonne de gauche et une colonne de droite, un espace vertical (30) séparant ladite colonne de gauche de ladite colonne de droite, chaque réseau de mémoire (26b) dans ladite colonne de gauche possédant un réseau de mémoire correspondant (26a) dans ladite colonne de droite, lesdits réseaux de mémoire (26) possédant une largeur dans ladite direction des colonnes;

pour chaque ligne dudit réseau de mémoire (26), deux desdites sections (32) de décodeurs sont disposées dans ledit espace vertical (30) pour s'étendre depuis ledit réseau de mémoire de gauche (26b) en direction dudit réseau de mémoire de droite (26a) et au voisinage l'un de l'autre; et

ledit conducteur (22) de transmission de signaux de commande est disposé de manière à traverser ledit espace vertical (30) entre lesdits réseaux (26) pour raccorder chacun desdits prédécodeurs (40).

9. Dispositif de mémoire selon la revendication 8, dans lequel la pluralité de conducteurs (24) de transmission de facteurs de lignes s'étendent d'une manière générale parallèlement à l'intérieur dudit espace vertical (30).

FIG. 1

EP 0 365 876 B1

FIG. 2

13

FIG. 3

EP 0 365 876 B1

FIG. 4

EP 0 365 876 B1